# EUROPEAN PATENT APPLICATION

(11) **EP 1 655 769 A2**
(43) Date of publication of application: **10.05.2006**
(21) Application number: 06100794.4
(22) Date of filing: 16.04.1998
(51) Int. Cl.: H01L 21/306

(54) **Method of cleaning a semiconductor device and cleaning agent for this purpose**

(30) Priority: 06.06.1997 EP 97201720
(62) Divisional of application: 98910950.9
(71) Applicant: Koninklijke Philips Electronics N.V., 5621 BA Eindhoven (NL)
(72) Inventor: Kordic, Srdjan, 5600 AE Eindhoven (NL); Knotter, Dirk, M., 5600 AE Eindhoven (NL); Mutsaers, Cornelis, A., H., A., 5600 AE Eindhoven (NL)
(74) Representative: Eleveld, Koop Jan

(57) **Abstract**

The invention provides a method of cleaning a semiconductor device with a semiconductor body (10) on whose surface are present an insulating layer (4) and a conductive layer (6,7) of a material comprising aluminum. As cleaning agent an aqueous solution of ozone and the mineral acid of hydrogen fluoride is chosen, wherein the acidity of the cleaning agent is adjusted through the addition of another mineral acid incapable of oxidation by ozone such that the conductive layer (6,7) of the material comprising aluminum is passivated during the cleaning process. This cleaning method gives excellent results as regards to continued planeness and smoothness of the conductive layer (6,7).

## Description

The invention relates to a method of cleaning a semiconductor device with a semiconductor body comprising a semiconductor substrate and at least two semiconductor regions which together form a pn junction and on whose surface are present an insulating layer and a conductive layer of a material comprising aluminum, for which method an aqueous solution of ozone and the mineral acid of hydrogen fluoride is chosen as cleaning agent.

Such a cleaning process is known, for example, from European patent EP 0.731.495 published on 11-09-1996. Owing to the higher reactivity with respect to the usual cleaning agent as mentioned above, however, an inadmissible roughening and even removal of the material comprising aluminum takes place also in this case. This leads to problems, such as a low yield, especially if, as is often the case, further conductive or insulating layers are to be provided.

It is an object of the present invention to provide a cleaning method of the kind mentioned in the opening paragraph, which is not subject to the above disadvantage. The invention also has for its object to provide a cleaning agent suitable for this purpose.

According to the invention, a cleaning method of the kind mentioned in the opening paragraph is for this purpose characterized in that the acidity of the cleaning agent is adjusted through the addition of another mineral acid incapable of oxidation by ozone such that the conductive layer of the material comprising aluminum is passivated during the cleaning process. Such a method is found to give excellent results, as regards to continued planeness and smoothness of the conductive layer, not only here, but also in cleaning in an earlier stage of the manufacture of a conductor track, i.e. after the aluminum layer required for it has been formed or after the thickness thereof has been reduced by chemical-mechanical polishing.

A suitable acidity of the cleaning agent is found to be one which lies in the pH range of between 2 and 7, while sulphuric acid, nitric acid, phosphoric acid, and boric acid are found to be the most suitable mineral acids. A substance may also advantageously added to the cleaning agent which reduces the surface tension thereof The addition of ultrasonic or preferably megasonic energy to the semiconductor body during the cleaning process also contributes to an excellent cleaning result.

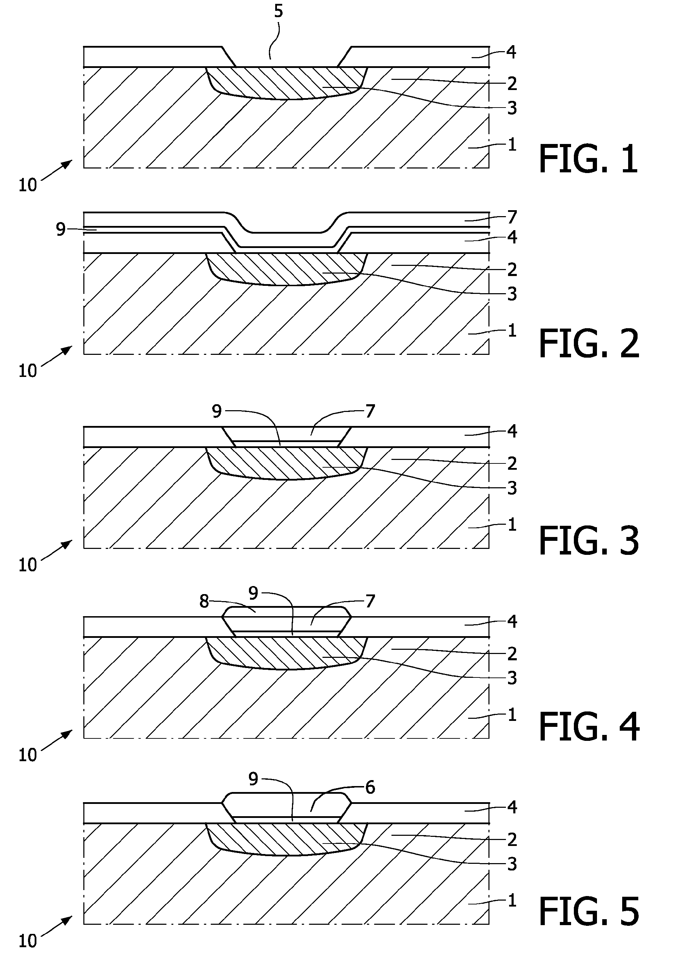

The invention will now be explained in more detail with reference to an embodiment and the accompanying drawing, in which
Figs. 1 to 5 are cross-sectional views taken perpendicular to the thickness direction of a semiconductor device manufactured by an embodiment of a method according to the invention in consecutive stages of manufacture.

The Figures are diagrammatic and not true to scale, the dimensions in the thickness direction being particularly exaggerated for greater clarity. Corresponding components have been given the same reference numerals in the various Figures as a rule. Semiconductor regions of the same conductivity type have been hatched in the same direction as a rule.

Figs. 1 to 5 are cross-sectional views taken perpendicular to the thickness direction of a semiconductor device manufactured by an embodiment of a method according to the invention in consecutive stages of manufacture. The formation of the semiconductor body 10 of the semiconductor device, an IC (= Integrated Circuit) in this case, starts with an n-type silicon substrate 1 (see Fig. 1) which is provided with an insulating layer 4 of silicon dioxide having a thickness of 1 µm by means of thermal oxidation. A recess 5, here a through opening 5, is formed in this layer by means of photolithography and etching. A p-type semiconductor region 3 is formed in the semiconductor body 10, for example by means of ion implantation, forming a pn junction together with the portion 2 of the substrate 1 lying outside it, which pn junction forms part of a MOS (= Metal Oxide Semiconductor) transistor, for example as the source. A conductive material 6 (see Fig. 5) is then provided in the opening 5 of the insulating layer 4, comprising two different materials, two metals in this case, i.e. aluminum (90% by weight) and copper (10% by weight). In the present example, a so-called barrier layer 9, comprising titanium nitride here, is present between the semiconductor region 3 to be contacted and the conductive material 6, where this conductive material 6 forms a contact.

The formation of the conductive material 6 takes, in this example, place as follows: first (see Fig. 2) a first layer 7 of the first material, i.e. aluminum in this case, is provided over the insulating layer 4 and the opening therein, for example by means of CVD (= Chemical Vapor Deposition). The thickness chosen for the first layer 7 is 2 µm in this example, so that the first layer 7 is thicker than the insulating layer 4. Before the first layer 7 is provided, a thin barrier layer 9 of titanium nitride is provided in this example, but this is immaterial to the invention. Then (see Fig. 3), a portion of the first layer 7 of aluminum is removed again chemically by means of a chemical etchant, here a dilute aqueous solution containing nitric acid, indeed, in a chemical-mechanical manner because a polishing disc and a slurry of silicon dioxide and aluminum oxide particles are also used during this. So much is removed of the first layer 7 in this example that only the opening 5 in the insulating layer 4 remains covered and filled with aluminum, while no aluminum is present any more outside the opening 5 on the insulating layer 4. The resulting thickness of the insulating layer 4 is then approximately 0.5 µm. Thanks to the use of the slurry mentioned above, the surface of the semiconductor body 10 and in particular of the aluminum present inside the opening 5 has a particularly planar and smooth structure. In addition, the aluminum 7 and the insulating layer 4 are excellently coplanar. Then (see Fig. 4) a second layer 8 of the second material, i.e. copper in this case, is provided on the first layer 7, by means of selective CVD in this case. The thickness chosen for the second layer 8 is approximately 0.015 µm, which is a small thickness compared with that of the first layer 7. This means that the material 7, 8 present in the opening 5 of the insulating layer 4 is still substantially coplanar with the insulating layer 4. The planeness and smoothness of the second layer 8 of copper is also excellent. In the present example, the second layer 8 is selectively deposited, which means that the thin layer 8 is not formed on the insulating layer 4. This has the advantage, not only of simplicity, but also that the risk of the semiconductor body 10 becoming contaminated with copper is small. Finally, the two materials 7, 8 now present in the opening 5 are intermixed by means of a suitable thermal treatment. The desired aluminum-copper alloy is formed inside the opening 5 thereby in this example. A suitable thermal treatment comprises, for example, baking of the semiconductor body 10 at a temperature of between 300 and 550 °C, in this case 450 °C.

The semiconductor body 10 may be excellently cleaned with a cleaning agent comprising an aqueous solution of ozone and the mineral acid of hydrogen fluoride both after the first layer 7 of aluminum has been provided and has been bulk-reduced by grinding and after the selective application of the second, thin layer 8 of copper and mixing thereof with the first layer 7 of aluminum. According to the invention, the best results are obtained as regards the continued planeness and smoothness of a layer 6, 7 comprising aluminum if the cleaning agent is given an acidity by means of a mineral acid other than hydrogen fluoride during cleaning such that the material 6, 7 comprising aluminum is passivated. The reactivity of the material 6, 7 comprising aluminum with respect to the cleaning agent is substantially suppressed thereby, so that said material 6, 7 is not or at least substantially not attacked. In the present example, the other mineral acid chosen is nitric acid, and the acidity chosen corresponds to pH = 4. The best results are obtained when, as in the present example, a surfactant such as soap is also added to the cleaning agent, and ultrasonic or, as in the present example, megasonic energy is supplied to the semiconductor body 10 during the cleaning process.

Further particulars of the semiconductor body 10 have been omitted for the sake of simplicity. These are the metallization of the substrate 1 and any further insulating or conductive layers which may be present above the insulating layer 4 and the conductive material 6 in the opening 5 therein, as well as further pn junctions of diodes or transistors which form part of the relevant IC. The steps necessary for these in a method according to the invention correspond to steps which are usual and will be carried out in a usual manner.

The invention is not limited to the embodiment given since many modifications and variations are possible to those skilled in the art within the scope of the invention. Thus compositions and thicknesses other than those mentioned in the example may be chosen for the various regions or layers. Other metals may be chosen for the first and the second material which are sufficiently far removed from one another in the electrochemical series, such as aluminum and vanadium or titanium. A combination of three or more metals is also possible. As was noted above, it is not necessary for the first and the second material to be both metals. The first material may be chosen to be, for example, polycrystalline or monocrystalline silicon, and the second material, for example, the metal cobalt. Cobalt silicide is then obtained in the thermal treatment.

Alternative techniques, for example sputtering, may be used for providing the first and the second layer. Copper may also be electrolytically provided on aluminum, or electrolessly from the liquid phase. It is also possible for the method according to the invention to be used more than once in the manufacture of semiconductor devices, for example for obtaining a multilayer wiring. The semiconductor regions 2 and 3 in the drawing may then comprise, for example, an insulating layer and a conductor track, respectively.

## Claims

1. A method of cleaning a semiconductor device with a semiconductor body (10) comprising a semiconductor substrate (1) and at least two semiconductor regions (2, 3) which together form a pn junction and on whose surface are present an insulating layer (4) and a conductive layer (6, 7) of a material comprising aluminum, for which method an aqueous solution of ozone and the mineral acid of hydrogen fluoride is chosen as cleaning agent, **characterized in that** the acidity of the cleaning agent is adjusted through the addition of another mineral acid incapable of oxidation by ozone such that the conductive layer (6, 7) of the material comprising aluminum is passivated during the cleaning process.

2. A method as claimed in claim 1, **characterized in that** the pH value of the cleaning agent is chosen to lie between 2 and 7, and that sulphuric acid, nitric acid, phosphoric acid, or boric acid is chosen as said other mineral acid.

3. A method as claimed in claim 1 or 2, **characterized in that** a substance is added to the cleaning agent by means of which the surface tension thereof is reduced, and **in that** ultrasonic, and preferably megasonic energy is supplied to the semiconductor body (10) during the cleaning process.

4. A cleaning agent suitable for use in a method as claimed in any one of the claims 1 to 3, comprising an aqueous solution of ozone and the mineral acid of hydrogen fluoride, **characterized in that** the cleaning agent also comprises a mineral acid incapable of oxidation by ozone other than hydrogen fluoride, has an acidity corresponding to a pH of between 2 and 7, and preferably also contains a substance which reduces the surface tension.
